# EUROPÄISCHE PATENTSCHRIFT

(11) **EP 0 913 933 B1**
(45) Veröffentlichungstag und Bekanntmachung des Hinweises auf die Patenterteilung: **26.05.2004**
(21) Anmeldenummer: 98120064.5
(22) Anmeldetag: 23.10.1998
(51) Int. Cl.: H03G 3/30

(54) **Steuervorrichtung zur Steuerung der Verstärkung eines HF-Verstärkers**
Device for controlling the amplification of a radiofrequency amplifier
Dispositif de commande de gain d'un amplificateur radiofréquence

(30) Priorität: 30.10.1997 DE 19747849
(43) Veröffentlichungstag der Anmeldung: 06.05.1999
(73) Patentinhaber: ROBERT BOSCH GMBH, 70442 Stuttgart (DE)
(72) Erfinder: Mader, Thomas, Dr., 47509 Rheurdt (DE); Kottschlag, Gerhard, 31139 Hildesheim (DE); Pitz, Gerhard, Dr., 31139 Hildesheim (DE)

(56) Entgegenhaltungen:
- EP-A- 0 369 135
- DE-A- 4 225 821
- US-A- 5 193 223

## Beschreibung

### Stand der Technik

Die Erfindung geht aus von einer Steuervorrichtung zur Steuerung der Verstärkung eines HF-Verstärkers nach der Gattung des unabhängigen Patentanspruchs. Aus der DE 42 25 821 ist bereits eine Vorrichtung zur Steuerung der Verstärkung eines HF-Verstärkers bekannt, die einen Prozessor mit einem nachgeschalteten Digital/Analog-Wandler aufweist. Durch das Ausgangssignal des Digital/Analog-Wandlers wird die Verstärkung eines Hochfrequenzverstärkers beeinflußt. Der Verstärkungsbereich des Hochfrequenzverstärkers ist für einen hohen Dynamikbereich in der Größenordnung von mehr als 30 dB ausgelegt. Entsprechend muß der Analog/Digital-Wandler bei vorgegebener Empfindlichkeit ebenfalls einen weiteren Bereich abdecken.

Die EP 369 135 A2 beschreibt eine Schaltungsanordnung zur Einstellung der Verstärkung eines HF-Verstärkers unter Verwendung eines Digital/Analog-Wandlers. Zur Glättung der Stufen bei Umschalten von einer zur anderen Verstärkung wird eine Schaltungsanordnung eingesetzt, mit der durch steuerbare Widerstände verschiedene Steigungen beim Übergang von der einen zur anderen Verstärkung erzielt werden. Auch hier muss der Digital/Analog-Wandler bei vorgegebener Empfindlichkeit einen weiten Dynamikbereich abdecken.

### Vorteile der Erfindung

Die erfindungsgemäße Steuervorrichtung mit den kennzeichnenden Merkmalen des unabhängigen Patentanspruchs hat demgegenüber den Vorteil, daß der Digital/Analog-Wandler einen deutlich verringerten Steuerungsbereich abdecken muß. Es können daher für den reduzierten Bereich mehr Abstufungen vorgesehen werden, oder aber der Digital/Anlalog-Wandler kann einfacher ausgestaltet werden.

Durch die in den abhängigen Ansprüchen aufgeführten Maßnahmen sind vorteilhafte Weiterbildungen und Verbesserungen der Steuervorrichtung nach dem unabhängigen Patentanspruch möglich. Besonders einfach wird dem weiteren Ausgang des Prozessors ein Pegelwandler nachgeordnet, der den digitalen Signalpegel in einen analogen Steuerpegel umsetzt. Dieser analoge Signalpegel kann dann besonders einfach durch ein Addierglied zu einem gemeinsamen Ansteuersignal des HF-Verstärkers vereint werden. Die erfindungsgemäße Steuervorrichtung läßt sich besonders vorteilhaft für einen Funksender verwenden, wobei dann das Ausgangssignal des Pegelwandlers allein zur Ansteuerung einer kleinsten Betriebsverstärkung des HF-Verstärkers ausreicht. Derartige Funksender sind insbesondere zur Verwendung in einem TDMA-Funktelefon geeignet.

### Zeichnungen

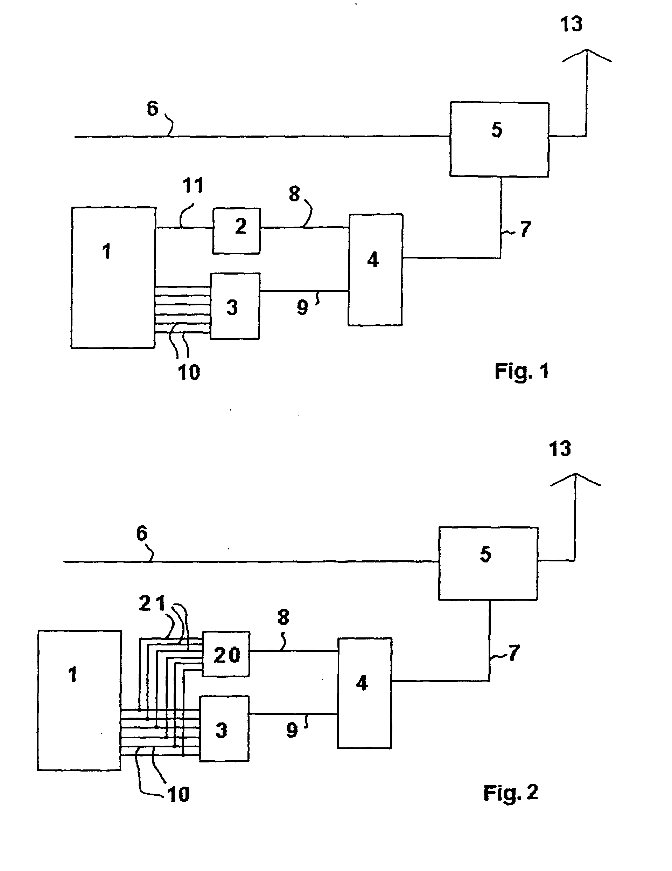

Ein Ausführungsbeispiel der Erfindung ist in der Zeichnung dargestellt und in der nachfolgenden Beschreibung näher erläutert. Es zeigen die Figur 1 eine erste und die Figur 2 eine zweite erfindungsgemäße Steuervorrichtung.

### Beschreibung

In der Figur 1 wird schematisch ein Teil eines Funksenders gezeigt. Über eine Übertragungsleitung 6 wird ein Hochfrequenz-Sendesignal an einen Hochfrequenz-Verstärker 5 gegeben. Die Leitung 6 verbindet den Hochfrequenz-Verstärker 5 beispielsweise mit einem Sendemodulator mit entsprechenden Treiber und Filterstufen. Im Hochfrequenz-Verstärker 5 wird das hochfrequente Sendesignal auf der Leitung 6 verstärkt und an eine Antenne 13 abgegeben. Die Höhe der Verstärkung hängt dabei von einem Analog-Signal ab, welches dem Hochfrequenz-Verstärker 5 auf der Zuleitung 7 zugeführt wird. Zur Einstellung des Analog-Signals auf der Zuleitung 7 ist ein Prozessor 1 vorgesehen, der mehrere Digitalleitungen 10 und eine weitere Digitalleitung 11 aufweist. Die mehreren parallel geschalteten Digitalleitungen 10 sind mit den Eingängen eines Digital/Analog-Wandlers 3 verbunden. Der Ausgang des Digital/Analog-Wandlers 3 ist über eine Leitung 9 mit einem Summierverstärker 4 verbunden. Die weitere digitale Signalleitung 11 des Prozessors 1 ist mit dem Eingang einer Pegelwandlerstufe 2 verbunden. Ein Ausgang der Pegelwandlerstufe 2 ist über eine Leitung 8 mit einem weiteren Eingang des Summierverstärkers 4 verbunden. Der Ausgang des Summierverstärkers 4 ist über die Leitung 7 mit dem Steuereingang des HF-Verstärkers 5 verbunden.

Die gezeigte Anordnung dient zur Erzeugung von Funksignalen wie sie für TDMA-Funksender (Time Division Multiple Access) verwendet werden. Bei derartigen TDMA-Funksendern, wie sie für digitale Telefonsysteme Verwendung finden, werden nur für kurze Zeiträume (in der Größenordnung von 500 Mikrosekunden) digitale Signale ausgesendet. Zwischen den einzelnen Sendeblöcken liegen Ruhephasen in denen die HF-Verstärker kein Ausgangssignal an die Antennen geben sollen. Während der Aussendung eines Datenpaketes muß die Verstärkung des HF-Verstärkers kontrolliert werden. Dies liegt darin begründet, daß zur Vermeidung von Störungen zwischen den verschiedenen Mobilstationen eines derartigen Funksystems jede Mobilstation nur mit der Leistung senden soll, die gerade erforderlich ist um eine Basisstation zu erreichen. Der HF-Verstärker 5 sollte daher entweder ausgeschaltet sein oder aber ausgehend von einer Mindestverstärkung (beispielsweise 5 dB) in vorgegebenen Stufen einen Bereich bis zur Maximalverstärkung (beispielsweise 33 dB) abdecken. Um die Verstärkung des HF-Verstärkers 5 zu regeln wird ihm an einem Eingang mittels der Leitung 7 ein analoges Steuersignal zugeführt. Zur Erzeugung dieses analogen Steuersignals gibt der Prozessor 1 über die Digitalleitungen 10 ein entsprechendes Digitalwort an den Digital/Analog-Wandler 3 der daraus eine analoge Spannung erzeugt. Die analoge Spannung gibt der Digital/Analog-Wandler 3 über die Leitung 9 an den Addierverstärker 4. Weiterhin gibt der Prozessor 1 noch ein weiteres Digitalsignal über die Leitung 11 an den Pegelwandler 2. Dieser Pegelwandler 2 erzeugt aus dem Digitalsignal des Prozessors 1, welches beispielsweise aus einem TLL-Signal mit einem Low-Pegel von 0,8 Volt und einem High-Pegel von 3,2 Volt einen gewünschten umgesetzten Pegel, beispielsweise einen Low-Pegel von 0 Volt und einen High-Pegel von 1 Volt. Die beiden Werte werden dabei so gewählt, daß der untere Wert für sich allein betrachtet keine Ansteuerung des HF-Verstärkers 5 bewirkt und der hohe Wert für sich allein betrachtet gerade die geringste im Betrieb auftretende Verstärkung des Hochfrequenzverstärkers 5 bewirkt. Diese Pegel des Pegelwandlers 2 werden dann an den Addierverstärker 4 gegeben. Durch das Digitalwort welches vom Prozessor 1 auf die Leitungen 10 gegeben wird und die nachfolgende Digital/Analog-Umsetzung werden dann die Analogspannungen erzeugt, die benötigt werden um zusätzlich zu der bereits vom Pegelumsetzer 2 erzeugten Analogspannung den Hochfrequenzverstärker 5 zwischen dem niedrigsten Verstärkungswert bis zum maximalen Verstärkungswert anzusteuern. Der gesamte Verstärkungsbereich unterhalb der geringsten Betriebsverstärkung des HF-Verstärkers 5 kann von dem Prozessor 1 durch ein einziges Bit welches auf die Leitung 11 ausgegeben wird, abgedeckt werden. Es ist für diesen Bereich nicht erforderlich, daß einzelne Zwischenstufen realisiert werden müssen. Es ist daher auch nicht erforderlich diesen Bereich durch einzelne feine Unterteilungen anzusteuern. Der Digital/Analog-Wandler 3 kann daher vergleichsweise einfach ausgelegt werden, da er nur noch den Verstärkungsbereich zwischen der niedrigsten Betriebsverstärkung und der höchsten Betriebsverstärkung abdecken muß.

Der Digital/Analog-Wandler muß somit nicht im gesamten Dynamikbereich, sondern nur den Bereich zwischen der Minimalverstärkung und der Maximalverstärkung abdecken. Die Auflösung des DA-Wandlers kann daher optimal genutzt werden. Diese Vorgehensweise ist besonders vorteilhaft, wenn die durch die Leitung 11 verursachte Zusatzspannung größer ist als die zur Ansteuerung des HF-Verstärkers benötigte Steuerspannung. In diesem Fall könnte durch die Erweiterung des Digital/Analogwandlers um ein weiteres Bit nicht der gesamte benötigte Dynamikbereich von Null bis zur Maximalspannung abgedeckt werden, so daß durch ein einzelnes Ansteuerbit auf der Leitung 11 eine größerer Bereich abgedeckt wird, als durch ein zusätzliches Ansteuerbit des Digital/Analog-Wandlers. Weiterhin kann die Erfindung auch vorteilhaft verwendet werden, wenn in dem Mikroprozessor bereits ein Digital/Analogwandler vorgesehen ist, dessen Auflösung und Dynamik nur für den Steuerbereich ausreicht. In diesem Fall kann ein sonst nicht benötigter Digitalausgang für die Leitung 11 verwendet werden. Weiterhin kann das Signal auf den Leitungen 11 oder 8 auch dazu verwendet werden den Digital/Analog-Wandler ein- und aus zu schalten. Ohne ein Signal auf diesen Leitungen ist der Digital/Analog-Wandler nicht im Betrieb, wodurch die Stromaufnahme verringert wird.

Eine weitere Ausführungsform der Erfindung, die ohne einen zusätzlichen Digitalausgang am Mikroprozessor auskommt, wird in der Figur 2 dargestellt. Die Bezugszeichen 1 bis 13 bezeichnen, soweit sie verwendet werden, wieder die gleichen Gegenstände wie in der Figur 1. Statt einer Digitalleitung 11 und eines Pegelwandlers 2, ist jedoch ein Oderglied 20 vorgesehen, welches durch Verbindungsleitungen 21 mit allen Digitalleitungen 10 verbunden ist. Für jede Digitalleitung 10 ist eine Verbindungsleitung 21 vorgesehen. Wenn auf allen Digitalleitungen 10 der Bitzustand Null anliegt, so liegt am Ausgang des Oderglieds 20 bzw. der Leitung 8 ebenfalls der Zustand Null an. Wenn an mindestens einer der Digitalleitungen 10 eine 1-Bit anliegt, so liegt am Ausgang des Oderglieds 20 bzw. der Leitung 8 ebenfalls ein 1-Bit bzw. eine Spannung an, die dann im Addierverstärker 4 hinzugefügt wird. Die Spannung auf der Leitung 8 wird dabei so ausgelegt, daß gerade der niedrigste Verstärkungswert im HF-Verstärker 5 bewirkt wird. Dazu ist in dem Oderglied oder nachgeordnet ein entsprechender Pegelwandler vorgesehen.

## Patentansprüche

1. Steuervorrichtung zur Steuerung der Verstärkung eines HF-Verstärkers (5), bei dem ein Prozessor (1) mit einem nachgeordneten Digital/Analog-Wandler (3) analoge Steuersignale zur Steuerung des HF-Verstärkers (5) erzeugt, **dadurch gekennzeichnet, dass** ein Pegelwandler (2, 20) vorgesehen ist, der einen digitalen Signalpegel in einen analogen Steuerpegel umsetzt, dass ferner ein Addierglied (4) vorgesehen ist, in dem dieser analoge Steuerpegel zum Ausgangssignalpegel des Digital/Analog-Wandlers (3) addiert wird, so dass eine vorgegebene Minimalverstärkung des HF-Verstärkers (5) bewirkt wird.

2. Steuervorrichtung nach Anspruch 1, **dadurch gekennzeichnet, daß** der Prozessor (1) einen weiteren Ausgang (11) aufweist, daß dem weiteren Ausgang (11) der Pegelwandler (2) nachgeordnet ist, der einen digitalen Signalpegel des Prozessors (1) in die zusätzliche Analogspannung umsetzt.

3. Steuervorrichtung nach Anspruch 2, **dadurch gekennzeichnet, daß** der Pegelwandler (2) oder ein Signal auf einer Leitung (11) ein Ansteuersignal für den Digital/Analogwandler (3) liefert, durch das der Digital/Analogwandler (3) ein- und ausgeschaltet wird.

4. Steuervorrichtung nach Anspruch 1, **dadurch gekennzeichnet, daß** der Digital/Analog-Wandler (3) mit einer Mehrzahl von Digitalleitungen (11) mit dem Prozessor (1) verbunden ist, daß jede der Digitalleitungen (11) mit einer Verbindungsleitung (21) mit einem Oderglied (20) verbunden ist, und daß das Oderglied (20) die zusätzliche Analogspannung erzeugt, wenn mindestens eine der Digitalleitungen (11) mit einem Signal beaufschlagt ist.

5. Steuervorrichtung nach Anspruch 3, **dadurch gekennzeichnet, daß** das Ausgangssignal des Pegelwandlers (2) oder des Oderglieds (20) und das Ausgangssignal des Digital/Analog-Wandlers (3) einem Addierglied (4) zugeführt wird.

6. Steuervorrichtung nach einem der vorhergehenden Ansprüche, **dadurch gekennzeichnet, daß** die Steuervorrichtung Teil eines Funksenders ist.

7. Steuervorrichtung nach Anspruch 6, **dadurch gekennzeichnet, daß** der Funksender als Teil eines TDMA-Funktelefons ausgebildet ist.

## Claims

1. Control device for controlling the gain of an RF amplifier (5), in which a processor (1) with a downstream digital/analogue converter (3) generates analogue control signals for controlling the RF amplifier (5), **characterized in that** a level converter (2, 20) is provided, which converts a digital signal level into an analogue control level, **in that** an addition element (4) is furthermore provided, in which the said analogue control level is added to the output signal level of the digital/analogue converter (3), with the result that a predetermined minimum gain of the RF amplifier (5) is effected.

2. Control device according to Claim 1, **characterized in that** the processor (1) has a further output (11), **in that** the level converter (2), which converts a digital signal level of the processor (1) into the additional analogue voltage, is arranged downstream of the further output (11).

3. Control device according to Claim 2, **characterized in that** the level converter (2) or a signal on a line (11) supplies a drive signal for the digital/analogue converter (3), by means of which drive signal the digital/analogue converter (3) is switched on and off.

4. Control device according to Claim 1, **characterized in that** the digital/analogue converter (3) is connected to the processor (1) by a plurality of digital lines (11), **in that** each of the digital lines (11) is connected to an OR element (20) by a connecting line (21), and **in that** the OR element (20) generates the additional analogue voltage if a signal is applied to at least one of the digital lines (11).

5. Control device according to Claim 3, **characterized in that** the output signal of the level converter (2) or of the OR element (20) and the output signal of the digital/analogue converter (3) are fed to an addition element (4).

6. Control device according to one of the preceding claims, **characterized in that** the control device is part of a radio transmitter.

7. Control device according to Claim 6, **characterized in that** the radio transmitter is designed as part of a TDMA radio telephone.

## Revendications

1. Dispositif de commande de gain d'un amplificateur radiofréquence (5) dans lequel un processeur (1) et un convertisseur numérique/analogique (3) disposé en aval créent des signaux de commande analogiques pour commander l'amplificateur radiofréquence (5),
**caractérisé en ce qu'**
un convertisseur de niveau (2, 20), convertit un niveau de signal numérique en niveau de commande analogique, en outre un additionneur (4) est prévu, dans lequel ce niveau de commande analogique est ajouté au niveau de signal de sortie du convertisseur numérique/analogique (3), de manière de réaliser un gain minimal prédéfini de l'amplificateur radiofréquence (5).

2. Dispositif de commande selon la revendication 1,
**caractérisé en ce que**
le processeur (1) présente une autre sortie (11), et le convertisseur de niveau (2) qui convertit un niveau de signal numérique du processeur (1) dans la tension analogique supplémentaire, est disposé après l'autre sortie (11).

3. Dispositif de commande selon la revendication 2,
**caractérisé en ce que**
le convertisseur de niveau (2), ou un signal sur une ligne (11), livre un signal de commande au convertisseur numérique/analogique (3), qui met sous tension et coupe le convertisseur numérique/analogique (3).

4. Dispositif de commande selon la revendication 1,
**caractérisé en ce que**
le convertisseur numérique/analogique (3) est raccordé au processeur (1) avec une multitude de lignes numériques (11), chacune des lignes numériques (11) est raccordée à un élément OU (20) avec une ligne de raccordement (21), et l'élément OU (20) crée la tension analogique supplémentaire lorsqu'au moins l'une des lignes numériques (11) est alimentée par un signal.

5. Dispositif de commande selon la revendication 3,
**caractérisé en ce que**
le signal de sortie du convertisseur de niveau (2) ou de l'élément OU (20) et le signal de sortie du convertisseur numérique/analogique (3) sont amenés à un additionneur (4).

6. Dispositif de commande selon l'une quelconque des revendications précédentes,
**caractérisé en ce que**
le dispositif de commande est une partie d'un émetteur radio.

7. Dispositif de commande selon la revendication 6,
**caractérisé en ce que**
l'émetteur radio est formé comme une partie d'un téléphone mobile AMRT.
